# EUROPÄISCHE PATENTANMELDUNG

(11) **EP 4 709 061 A1**
(43) Veröffentlichungstag der Anmeldung: **11.03.2026**
(21) Anmeldenummer: 25197991.0
(22) Anmeldetag: 25.08.2025
(51) Int. Cl.: H05K 1/02, H05K 13/00, H05K 7/14, H05K 7/20, H05K 9/00

(54) **FÜHRUNGS- UND ISOLATIONSPLATTE FÜR EINE ELEKTRONISCHE HOCHVOLTVORRICHTUNG, ELEKTRONISCHE HOCH-VOLTVORRICHTUNG MIT EINER FÜHRUNGS- UND ISOLATIONSPLATTE UND VERFAHREN ZUR HERSTELLUNG EINER ELEKTRONISCHEN HOCHVOLTVORRICHTUNG**

(30) Priorität: 28.08.2024 DE 102024208197
(71) Anmelder: VOLKSWAGEN AG, 38440 Wolfsburg (DE)
(72) Erfinder: Wehry, Eduard, 38440 Wolfsburg (DE); Söhnle, Benjamin, 38440 Wolfsburg (DE); Florian, Riese, 38440 Wolfsburg (DE); Pries, Marcel, 38440 Wolfsburg (DE)

(57) **Zusammenfassung**

Die Erfindung betrifft eine Führungs- und Isolationsplatte (10) für eine elektronische, eine Leiterplatte aufweisende Hochvoltvorrichtung (12), wobei die Führungs- und Isolationsplatte (10) einen plattenartigen Abschnitt (14) und eine Mehrzahl von in dem plattenartigen Abschnitt (14) eingefassten Einführhilfen (16) aufweist. Aufgabe der Erfindung ist es, eine Führungs- und Isolationsplatte für eine elektronische Hochvoltvorrichtung bereitzustellen, die eine besonders einfache Montierbarkeit ermöglicht und mit der gleichzeitig der zur Verfügung stehende Bauraum besonders effizient genutzt werden kann. Diese Aufgabe wird dadurch gelöst, dass der plattenartige Abschnitt (14) lokal ausgebildete, dünnwandige Bereiche (18) und dickwandige Bereiche (20) aufweist.

## Beschreibung

Die Erfindung betrifft eine Führungs- und Isolationsplatte für eine elektronische, eine Leiterplatte aufweisende Hochvoltvorrichtung, wobei die Führungs- und Isolationsplatte einen plattenartigen Abschnitt und eine Mehrzahl von in dem plattenartigen Abschnitt eingefassten Einführhilfen aufweist. Die Erfindung betrifft ferner eine elektronische Hochvoltvorrichtung, insbesondere eine Hochvolt-Steuervorrichtung eines Kraftfahrzeugs, sowie ein Verfahren zur Herstellung einer elektronischen Hochvoltvorrichtung.

Zur Erzielung der zum Betrieb des Antriebsmotors eines Hybrid-Elektro-Fahrzeuges oder Elektro-Fahrzeugs geforderten Leistungs- und Energiedaten wird regelmäßig eine Vielzahl einzelner Batteriezellen in Serie oder auch parallel geschaltet, so dass sich eine Gesamtspannung eines Batteriesystems von mehr als 200 V, mehr als 300 V, mehr als 400 V oder auch mehr als 800 V ergeben kann. Häufig werden Batteriesysteme mit einer Spannung zwischen 200 V und 1200 V verwendet, besonders bevorzugt mit einer Spannung zwischen 400 V und 800 V. Im Rahmen dieser Anmeldung werden Vorrichtungen und Bauteile, an welchen Spannungen von 200 V und mehr anliegen, als Hochvoltvorrichtungen und Hochvoltbauteile bezeichnet.

Zur Steuerung des elektrischen Antriebsmotors der vorbezeichneten Hybrid-Elektro-Fahrzeuge und Elektro-Fahrzeuge wird häufig eine elektronische Hochvoltvorrichtung, insbesondere eine Hochvolt-Steuervorrichtung eingesetzt. Diese elektronische Hochvoltvorrichtung weist regelmäßig zumindest einen elektrisch leitfähigen Montageträger und eine Leiterplatte mit einer Mehrzahl von Hochvoltbauteilen, Leiterbahnen und Löchern auf. An dem Montageträger ist ein Hochvoltmodul angeordnet, das eine Mehrzahl von hervorragenden und die Löcher der Leiterplatte hindurchragenden Kontaktstiften aufweist.

Aufgrund der hohen in den vorgenannten Hochvoltvorrichtungen vorherrschenden Leistungsdichten sind in der Praxis spezielle konstruktive Aufbauten dieser Hochvoltvorrichtungen notwendig, die die Anforderungen von mechanischer Haltbarkeit, elektromagnetischer Verträglichkeit und Wärmeabfuhr berücksichtigen.

Die sich dabei ergebenden konstruktiven Herausforderungen werden zusätzlich durch den Wunsch nach einer möglichst einfachen und automatisierbaren Montierbarkeit der leistungselektronischen Einrichtung noch verschärft.

In der Vergangenheit haben sich daher einige Detaillösungen für die Überwindung der sich beim Zusammenbau derartiger leistungselektronischer Einrichtungen ergebenden Herausforderungen herausgebildet.

So ist beispielsweise aus der DE 10 2019 219 282 A1 ein Stromrichter für ein Fahrzeug mit einer Leiterplatte bekannt, bei dem die Leiterplatte über mehrere als Pins bezeichnete Kontaktstifte mit wenigstens einem Bauteil verbunden ist. Dabei weist die Leiterplatte für einen jeweiligen Pin eine als Zentrierhilfe bezeichnete Einführhilfe an einer dem Bauteil zugewandten Seite auf. Die Einführhilfen erleichtern es den Pins, beim Zusammenbau des Stromrichters in die jeweilige Bohrung zu gelangen, indem die Pins durch die Zentrierhilfe zu ihrer jeweiligen Bohrung hin geführt werden.

Die WO 2012/085397 A1 offenbart eine ähnliche Einführhilfe. Dabei erstreckt sich die Einführhilfe flächig zwischen dem Bauteil unter der Leiterplatte und weist dabei eine Vielzahl trichterförmig gestalteter Führungsbereiche zum Führen einer Vielzahl an Pins zu den ihnen zugeordneten Löchern in der Leiterplatte auf.

Weiter zeigt die EP 3 177 123 B1 einen Spannungswandler, bei dem eine Elektronikkarte auf einem Träger angeordnet ist. Die Elektronikkarte ist mit einem Bauteil, das auf der von der Elektronikkarte abgewandten Seite des Trägers angeordnet ist, mittels eines Einsteckkontakts verbunden. Der Träger weist Führungselemente auf, um die Einsteckkontakte zu den entsprechenden Aufnahmekontakten der Elektronikkarte zu führen.

Weitere Einführhilfen sind aus der DE 10 2018 110 752 A1 und aus der DE 10 2006 002 457 A1 bekannt, wobei die darin offenbarten Einführhilfen als einzelne, in Löcher der Leiterplatte eingesetzte Hülsen bzw. Buchsen ausgebildet sind.

Der Erfindung liegt die Aufgabe zugrunde, eine Führungs- und Isolationsplatte für eine elektronische Hochvoltvorrichtung, eine elektronische Hochvoltvorrichtung mit einer Führungs- und Isolationsplatte und ein Verfahren zur Herstellung einer elektronischen Hochvoltvorrichtung bereitzustellen, die eine besonders einfache Montierbarkeit ermöglichen und mit denen gleichzeitig der zur Verfügung stehende Bauraum besonders effizient genutzt werden kann. Ferner ist es die Aufgabe, Gewicht bei den vorgenannten Gegenständen zu reduzieren und die Betriebssicherheit eines Kraftfahrzeugs mit diesen Gegenständen zu verbessern.

Die Lösung der Aufgabe erfolgt erfindungsgemäß mit den Merkmalen der unabhängigen Ansprüche. Weitere praktische Ausführungsformen und Vorteile der Erfindung sind in Verbindung mit den abhängigen Ansprüchen beschrieben.

Die Führungs- und Isolationsplatte ist zur Integration in eine elektronische, eine Leiterplatte aufweisende Hochvoltvorrichtung ausgelegt. Die Führungs- und Isolationsplatte weist einen plattenartigen Abschnitt und eine Mehrzahl von in dem plattenartigen Abschnitt eingefassten Einführhilfen auf. Ferner weist der plattenartige Abschnitt lokal ausgebildete, dünnwandige Bereiche und dickwandige Bereiche auf.

Die Führungs- und Isolationsplatte ist insbesondere zur Anordnung zwischen der Leiterplatte und einem elektrisch leitfähigen Montageträger einer in dieser Anmeldung beschriebenen Hochvoltvorrichtung ausgelegt. Eine derart angeordnete Führungs- und Isolationsplatte dient dazu, die Anforderungen an Luft- und Kriechstrecken, die zur Gewährleistung einer hinreichenden elektrischen Isolation zwischen dem elektrisch leitfähigen Montageträger und der Leiterplatte mit Hochvoltbauteilen bestehen, zu erfüllen. Zu diesem Zweck weist die Führungs- und Isolationsplatte den plattenartigen Abschnitt auf. Die Führungs- und Isolationsplatte kann beispielsweise vollständig oder teilweise als ein Spritzgussteil aus einem Grundmaterial mit geringer elektrischer Leitfähigkeit, beispielsweise einem Kunststoff, gebildet sein. Zur Erhöhung der Festigkeit kann in dem Grundmaterial ein Glasfaseranteil enthalten sein.

Die Leiterplatte und der Montageträger können sich in der Praxis flächig in zueinander parallelen Erstreckungsebenen erstrecken. Der plattenartige Abschnitt der Führungs- und Isolationsplatte kann sich ebenfalls in einer Ebene flächig in einer Erstreckungsebene erstrecken. Wenn sich der plattenartige Abschnitt flächig in einer Ebene erstreckt und in einer Hochvoltvorrichtung parallel zu der Erstreckungsebene des Montageträgers und/oder der Leiterplatte angeordnet ist, kann ein insgesamt kompakter "geschichteter" Aufbau der Hochvoltvorrichtung erzielt werden, der einfach zu montieren ist und in mechanischer, thermischer und elektromagnetischer Hinsicht von der Kombination des elektrisch leitfähigen Montageträgers mit der Führungs- und Isolationsplatte profitiert.

Die Führungs- und Isolationsplatte weist eine Mehrzahl von in dem plattenartigen Abschnitt eingefassten Einführhilfen auf. Diese Einführhilfen dienen beim Zusammenbau einer in dieser Anmeldung beschriebenen Hochvoltvorrichtung dem Ausrichten von Kontaktstiften auf Löcher in der Leiterplatte der Hochvoltvorrichtung. Der Vorteil, die notwendige elektrische Isolation zwischen der Leiterplatte und dem metallischen Montageträger durch die flächige Führungs- und Isolationsplatte sicherzustellen, liegt darin, dass die Führungs- und Isolationsplatte in vorteilhafter Weise auch zum Ausrichten der Kontaktstifte auf die Löcher in der Leiterplatte beim Zusammenbau der Hochvoltvorrichtung genutzt werden kann. Die Vereinigung einer elektrischen Isolationswirkung und der Einführhilfen in einem einzigen Bauteil ermöglicht darüber hinaus eine sehr einfache Montierbarkeit der Hochvoltvorrichtung, da vergleichsweise wenige Elemente bei der Montage miteinander verbunden werden müssen.

Die Einführhilfen können insbesondere als sich zur Leiterplatte hin verjüngende Durchlässe gebildet sein. Derartige, sich zur Leiterplatte hin verjüngende Durchlässe sind geeignet, um einen Kontaktstift einer Hochvoltvorrichtung, wenn sich dieser beim Montieren der Hochvoltvorrichtung der Leiterplatte nähert, hinsichtlich seiner exakten räumlichen Ausrichtung zu korrigieren. Der Kontaktstift dringt dabei mit seiner Spitze voran in den sich verjüngenden Durchlass ein und gleitet von den den Durchlass begrenzenden Wänden ab, wodurch die Spitze des Kontaktstiftes zum Loch in der Leiterplatte hin geführt wird. Die Durchlässe können insbesondere trichterartig gestaltet sein. Durch eine trichterartige Gestaltung können Abweichungen des Kontaktpins von seiner Idealposition in jeder Richtung innerhalb der Erstreckungsebene der Führungs- und Isolationsplatte korrigiert werden.

Der plattenartige Abschnitt weist lokal ausgebildete, dünnwandige Bereiche und dickwandige Bereiche auf. Dabei sind die dünnwandigen Bereiche in der Erstreckungsebene des plattenartigen Abschnitts von den dickwandigen Bereichen umgeben. Die dünnwandigen Bereiche sind also sinngemäß in Gestalt von lokalen Inseln in den dickwandigen Bereichen ausgebildet. Die dünnwandigen Bereiche können beispielsweise derart ausgebildet und die Führungs- und Isolationsplatte derart in einer in dieser Anmeldung beschriebenen Hochvoltvorrichtung anordnbar sein, dass die dünnwandigen Bereiche bestimmungsgemäß an von der Leiterplatte hervorragenden Bauteilen, insbesondere hervorragenden Hochvoltbauteilen, beabstandet angrenzen. Die von der Leiterplatte hervorragenden Bauteilen können im montierten Zustand der Hochvoltvorrichtung dann sinngemäß in dem plattenartigen Abschnitt einsinken. Anders ausgedrückt kann der plattenartige Abschnitt die hervorragenden Bauteile dann sinngemäß zumindest teilweise umschließen. Die Führungs- und Isolationsplatte kann dadurch insgesamt besonders nahe an der Leiterplatte und/oder dem Montagemodul angeordnet sein. Dadurch ist es in vorteilhafter Weise möglich, den erforderlichen Bauraum zu reduzieren, ohne die mechanische Stabilität und die elektrische Isolationswirkung der Führungs- und Isolationsplatte spürbar zu reduzieren. Zudem wird durch diese Ausbildung der Führungs- und Isolationsplatte ihr Gewicht reduziert.

Mit Hinblick auf die Isolationswirkung ist es vorteilhaft, wenn die dickwandigen und die dünnwandigen Bereiche eine Kriechstromfestigkeit von mindestens 400 CTI aufweisen, um eine ausreichend hohe Durchschlagsfestigkeit zu erzielen. Der CTI-Wert steht für "Comparative Tracking Index", dient als Maß für die Bewertung der Kriechstromfestigkeit und sagt aus, bis zu welcher Spannung, gemessen in Volt, das bewertete Basismaterial keine elektrische Leitfähigkeit zeigt, wenn 50 Tropfen genormter Elektrolytlösungen aufgetropft werden. Bevorzugt ist die Kriechstromfestigkeit der dickwandigen und der dünnwandigen Bereiche höher als 600 CTI. Kriechstromfestigkeiten von mehr als 400 CTI bzw. mehr als 600 CTI können insbesondere durch die Bildung des plattenartigen Abschnitts aus Isolierstoffen der Isolierstoffgruppe II bzw. aus der Isolierstoffgruppe I, gemäß der Norm EN 60664-1:2007, erzielt werden.

Die dickwandigen Bereiche können insbesondere eine Dicke von mindestens 1,5 mm, bevorzugt mindestens 1,8 mm, und von höchstens 2,5 mm, bevorzugt höchstens 2,0 mm, senkrecht zur Erstreckungsebene des plattenartigen Abschnitts aufweisen. Größere Dicken als 2,5 mm sind für den plattenartigen Abschnitt der Führungs- und Isolationsplatte nicht zielführend, weil dadurch der Bauraum des Hochvoltmoduls, in welchem die Führungs- und Isolationsplatte integriert ist, vergrößert wird.

Die dünnwandigen Bereiche können insbesondere eine Dicke von mindestens 0,1 mm, bevorzugt mindestens 0,5 mm, und von höchstens 1,0 mm, bevorzugt höchstens 0,8 mm, senkrecht zur Erstreckungsebene des plattenartigen Abschnitts aufweisen. Bei der Mindestdicke insbesondere der dünnwandigen Bereiche ist zu berücksichtigen, dass die mechanische Festigkeit, die Isolationswirkung und/oder die Brandschutzfestigkeit mit abnehmender Wandstärke reduziert sein können.

Wie erwähnt, kann die Führungs- und Isolationsplatte vollständig als ein Spritzgussteil ausgebildet sein. Die dünnwandigen Bereiche, die Einführhilfen und die Zentrierelemente können bei der Herstellung mittels Spritzguss einteilig mit den dickwandigen Bereichen ausgebildet sein. Diese einteilige Ausbildung ist besonders einfach und erlaubt gleichzeitig die Herstellung komplexer Geometrien. Allerdings kann in diesem Fall die Isolationswirkung und insbesondere die Kriechstromfestigkeit insbesondere der dünnwandigen Bereiche reduziert sein, weil beim Spritzgießen entstehende und die Isolationswirkung reduzierende Werkstoffunregelmäßigkeiten, beispielsweise in Gestalt von Lunkern, in dünnwandigen Bereichen vermehrt auftreten.

Alternativ zu der einteiligen Ausbildung kann die Führungs- und Isolationsplatte und insbesondere der plattenartige Abschnitt mehrteilig ausgebildet sein. Dabei können insbesondere die dünnwandigen Bereiche separat von den übrigen durch Spritzgießen hergestellten Bestandteilen erzeugt oder zumindest fertiggestellt werden. Beispielsweise kann der plattenartige Abschnitt in einem ersten Schritt mittels Spritzguss als Halbzeug hergestellt und die dünnwandigen Bereiche in einem zweiten Schritt nachträglich in das Halbzeug eingebracht werden. In diesem Kontext ist es möglich, dass der plattenartige Abschnitt mit homogener Dicke spritzgegossen wird und anschließend Grundmaterial des spritzgegossenen Halbzeugs mit spanenden, thermischen und/oder elektrochemischen Verfahren aus dem plattenartigen Abschnitt entfernt wird, wobei die dünnwandigen Bereiche in Form von Vertiefungen mit dünnwandig ausgebildetem Grundmaterial ausgebildet werden. Zusätzlich oder alternativ ist es auch möglich, dass der plattenartige Abschnitt mehrteilig aufgebaut ist. Beispielsweise können die dickwandigen Bereiche aus dem Grundmaterial spritzgegossen werden und die dünnwandigen Bereiche dabei zunächst ausgespart bleiben. Die dünnwandigen Bereiche können durch Anfügen von separaten Elementen in oder an den Aussparungen bzw. den Vertiefungen erzeugt bzw. fertiggestellt werden.

In der Praxis kann der plattenartige Abschnitt eine Isolationsfolie zur elektrischen Isolation aufweisen. Insbesondere können zumindest die dünnwandigen Bereiche die Isolationsfolie zur elektrischen Isolation aufweisen. Die Isolationsfolie kann beispielsweise zusätzlich zu dem Grundmaterial, aus welchem der plattenartige Abschnitt ausgebildet ist und welches in den dünnwandigen Bereichen dünner ausgebildet sein kann als in den dickwandigen Bereichen, als separates Element an dem Grundmaterial angebracht oder in das Grundmaterial eingebracht sein. Die elektrische Isolation insbesondere des dünnwandig ausgebildeten Grundmaterials, welche aufgrund der im Vergleich zu den dickwandigen Bereichen geringeren Wandstärke geringer sein kann als die der dickwandigen Bereiche, kann dadurch gezielt erhöht werden.

Alternativ zu dem Einbringen oder Anbringen der Isolationsfolie in oder an dem dünnwandig ausgebildeten Grundmaterial können die dünnwandigen Bereiche auch ausschließlich aus der Isolationsfolie bestehen. Die dickwandigen Bereiche des plattenartigen Abschnitts sind dann aus dem Grundmaterial gebildet. Die dünnwandigen Bereiche sind dann aus der Isolationsfolie gebildet, welche zumindest Aussparungen in den dickwandigen Bereichen abdeckt und mit dem Grundmaterial der dickwandigen Bereiche verbundenen ist. Die Isolationsfolie kann bevorzugt eine Dicke von mindestens 0,1 mm, bevorzugt mindestens 0,5 mm, und von höchstens 1,0 mm, bevorzugt höchstens 0,8 mm, senkrecht zur Erstreckungsebene des plattenartigen Abschnitts aufweisen.

Die Isolationsfolie kann bevorzugt eine Kriechstromfestigkeit von höher als 400 CTI und weiter bevorzugt höher als 600 CTI aufweisen. In diesem Kontext wird auch auf die Beschreibung des CTI-Werts sowie auf die Isolierstoffgruppen der Norm EN 60664-1:2007 hingewiesen. Insbesondere kann die Isolationsfolie Glimmer, bevorzugt Glimmerpapier, aufweisen. Als Glimmer wird eine Gruppe von Mineralen aus der Abteilung der Schichtsilikate bezeichnet. Glimmer weist eine Schicht-Struktur, schwache Bindungen der Schichten untereinander und eine geringe elektrische Leitfähigkeit auf.

In der Praxis kann die Isolationsfolie an dem oder in dem gesamten plattenartigen Abschnitt der Führungs- und Isolationsplatte vorgesehen sein. Dadurch kann die Isolationsfolie auf einfache Weise großflächig appliziert werden. Alternativ kann es vorteilhaft sein, wenn die Isolationsfolie stückweise lokal in oder an den dünnwandigen Bereichen angeordnet ist. In oder an den dünnwandigen Bereichen wirkt sich die Isolationsfolie besonders effektiv auf die elektrische Isolation aus, so dass die lokale Applikation in oder an den dünnwandigen Bereichen den Effekt der Isolationsfolie besonders gezielt bewirken kann.

In der Praxis kann die Isolationsfolie als eine Verbund-Isolationsfolie ausgebildet sein, welche eine Mehrzahl von aufeinander geschichteten Folien aufweist. Dadurch ist es möglich, eine bevorzugte Kombination von Eigenschaften zu erzielen. Insbesondere kann die Verbund-Isolationsfolie eine den Glimmer aufweisende Folie zur Erhöhung der elektrischen Isolation umfassen. Zusätzlich oder alternativ kann die Verbund-Isolationsfolie eine Folie zur Einstellung einer definierten Wärmeleitfähigkeit aufweisen. Dadurch können beispielsweise Wärmeströme in dem plattenartigen Abschnitt gezielt geleitet werden. Die Folie zur Einstellung einer definierten Wärmeleitfähigkeit kann beispielsweise die Wärmeleitung beeinflussende Poren oder eingebettete Partikel aufweisen. Weiter zusätzlich oder alternativ kann die Verbund-Isolationsfolie eine Folie zur Verbesserung der Brandschutzfestigkeit aufweisen.

In der Praxis können die Isolationsfolie und das Grundmaterial des plattenartigen Abschnitts formschlüssig und/oder stoffschlüssig verbunden sein. Für die formschlüssige Verbindung kann die Isolationsfolie vollständig oder teilweise, insbesondere am Rand, von dem Grundmaterial umgeben und insbesondere umspritzt sein. Die Isolationsfolie ist dann zumindest teilweise in dem Grundmaterial eingebettet. Für die stoffschlüssige Verbindung kann beispielsweise eine Schweißverbindung, insbesondere eine Laserschweißverbindung, oder eine Klebeverbindung zwischen dem Grundmaterial des plattenartigen Abschnitts und der Isolationsfolie ausgebildet sein.

In der Praxis kann der plattenartige Abschnitt segmentiert ausgebildet sein, wobei mindestens zwei Segmente des plattenartigen Abschnitts mittels elastischer Verbindungselemente miteinander verbundenen sind. Aufgrund der elastischen Verbindungselemente sind die plattenartig ausgebildeten Segmente relativ zueinander beweglich. Derartige Ausgestaltungen haben den Vorteil, dass jedes einzelne Segment eine geringere flächige Erstreckung aufweisen kann als ein einzelner plattenartiger Abschnitt, der sich flächig erstreckt. Durch die geringere flächige Erstreckung ist es mit Hinblick auf das hier beschriebene Hochvoltbauteil einfacher, enge Toleranzen hinsichtlich der räumlichen Lage, insbesondere der Bohrungen und Einführelemente relativ zueinander einzuhalten. Durch die elastischen Verbindungselemente können Lagetoleranzen zwischen den einzelnen Segmenten im Rahmen der Montage der Hochvoltvorrichtung ausgeglichen werden.

Zusätzlich oder alternativ kann die Führungs- und Isolationsplatte eine Mehrzahl von Zentrierelementen aufweisen. Die Zentrierelemente dienen zur räumlichen Ausrichtung der Führungs- und Isolationsplatte relativ zur Leiterplatte. Zu diesem Zweck sind sie dazu ausgebildet, mit komplementär ausgebildeten Zentriergegenelementen der Leiterplatte zu wechselwirken. Bei den Zentrierelementen kann es sich beispielsweise um von dem plattenartigen Abschnitt der Führungs- und Isolationsplatte hervorragende Zentrierelemente handeln, die bei bestimmungsgemäßer Anordnung der Führungs- und Isolationsplatte in einer Hochvoltvorrichtung in Richtung der Leiterplatte hervorragen und die in entsprechende, als Aufnahmen gestaltete Zentriergegenelemente der Leiterplatte eingreifen. Hierbei können sich die Zentrierelemente in der Richtung, in welcher sie von dem plattenartigen Abschnitt hervorragen, verjüngen, so dass beim Verbinden der Leiterplatte mit der Führungs- und Isolationsplatte eine Zentrierung der Führungs- und Isolationsplatte relativ zur Leiterplatte erfolgt, wenn die Führungs- und Isolationsplatte und die Leiterplatte aufeinander zu bewegt werden. Unter Zentrierung ist in diesem Zusammenhang insbesondere die räumliche Ausrichtung in Bezug auf die Erstreckungsebene von Führungs- und Isolationsplatte und Leiterplatte zu verstehen.

Die Erfindung betrifft auch eine elektronische Hochvoltvorrichtung, insbesondere eine Hochvolt-Steuervorrichtung eines Kraftfahrzeugs. Die Hochvoltvorrichtung umfasst
- eine Leiterplatte, die eine Mehrzahl von Hochvoltbauteilen, Leiterbahnen und Löchern aufweist,
- einen elektrisch leitfähigen Montageträger, und
- ein an dem elektrisch leitfähigen Montageträger angeordnetes Hochvoltmodul, das eine Mehrzahl von hervorragenden und die Löcher der Leiterplatte hindurchragenden Kontaktstifte aufweist.

Die Hochvoltvorrichtung weist ferner eine hier beschriebene Führungs- und Isolationsplatte auf, wobei die Führungs- und Isolationsplatte zwischen mindestens einem Abschnitt der Leiterplatte und dem Montageträger angeordnet ist.

Die von dem Hochvoltmodul hervorragenden Kontaktstifte sind zur Kontaktierung der Leiterplatte durch die Löcher in der Leiterplatte geführt und dienen der elektrischen Verbindung des Hochvoltmoduls mit der Leiterplatte. Bei den Kontaktstiften kann es sich um sogenannte Press-Fit-Pins handeln. Bei Press-Fit-Pins handelt es sich um Kontaktstifte, die derart gestaltet sind, dass sich durch eine elastische Verformung des Press-Fit-Pins dessen Querschnitt beim Durchführen des Press-Fit-Pins durch eine geeignete Öffnung reduzieren lässt. Aufgrund der elastischen Rückstellkräfte können die Press-Fit-Pins so kraftschlüssig in einer geeignet dimensionierten Öffnung, in die sie unter Erzeugung einer elastischen Verformung des Press-Fit-Pins eingeführt worden sind, gehalten werden. Durch die im Rahmen des Kraftschlusses wirkenden Anpresskräfte entsteht so auch ein inniger elektrischer Kontakt, der die Verwendung von Press-Fit-Pins für elektronische Hochvoltvorrichtungen der in Rede stehenden Art prädestiniert.

Die Hochvoltvorrichtung weist ferner den elektrisch leitfähigen Montageträger auf, an dem das Hochvoltmodul und die Leiterplatte befestigt sind. Der Montageträger kann beispielsweise flächig zwischen der Leiterplatte und dem Hochvoltmodul oder außen neben einem dieser Elemente angeordnet sein. Insbesondere kann der Montageträger aus einem metallischen Werkstoff gebildet sein. Der Montageträger bietet die Möglichkeit, eine Reihe von Funktionen in einem Bauteil zu vereinigen. Zunächst stellt er eine robuste Befestigungsmöglichkeit für die Leiterplatte und das leistungselektronische Modul dar.

Des Weiteren kann der Montageträger, und insbesondere ein metallischer Montageträger, eine gute thermische Leitfähigkeit bieten, weswegen der Montageträger zur Wärmeabfuhr aus dem Bereich zwischen Leiterplatte und leistungselektronischem Modul beitragen kann. Gerade Hochvoltmodule erzeugen häufig nicht unbeträchtliche Mengen an Wärmeenergie. Durch die verbesserte Wärmeabfuhr aus dem Bereich der Leiterplatte und dem Hochvoltmodul, die durch den Montageträger erreicht werden kann, wird die Gefahr einer schädlichen Auswirkung dieser Wärme auf die Leiterplatte und insbesondere auf die Hochvoltbauteile und/oder die Leiterbahnen der Leiterplatte verringert.

Weiterhin lässt sich der Montageträger, und insbesondere ein metallischer Montageträger, zur Verbesserung der elektromagnetischen Verträglichkeit nutzen. Gerade Hochvoltmodule stellen im Hinblick auf ihre elektromagnetische Verträglichkeit kritische Bauelemente dar. Der Montageträger kann dazu geeignet sein, elektromagnetische Störstrahlung, die insbesondere von dem Hochvoltmodul ausgehen kann, gegenüber der Leiterplatte und/oder der Umgebung abzuschirmen.

Weiter weist die Hochvoltvorrichtung die im Detail beschriebene Führungs- und Isolationsplatte auf, welche zwischen mindestens einem Abschnitt der Leiterplatte und dem Montageträger angeordnet ist. Die Führungs- und Isolationsplatte dient dazu, die Kontaktstifte auf die Löcher in der Leiterplatte beim Zusammenbau der Hochvoltvorrichtung auszurichten und die Anforderungen an Luft- und Kriechstrecken, die zur Gewährleistung einer hinreichenden elektrischen Isolation zwischen dem elektrisch leitfähigen Montageträger und der Leiterplatte bestehen, zu erfüllen. In diesem Kontext wird noch einmal auf den möglichen "geschichteten" Aufbau der Hochvoltvorrichtung und die sehr einfache Montierbarkeit der Hochvoltvorrichtung Bezug genommen.

Bei der Hochvoltvorrichtung kann es sich insbesondere um eine Hochvolt-Steuervorrichtung oder um einen Bestandteil einer Hochvolt-Steuervorrichtung handeln. Beispielsweise kann die Hochvoltvorrichtung eine leistungselektronische Einrichtung und insbesondere ein Pulswechselrichter zur Versorgung eines elektrischen Antriebs mit elektrischer Energie sein. Bei derartigen Pulswechselrichtern können die spezifischen Vorteile, die sich aus der hier beschriebenen Konstruktion der Hochvoltvorrichtung ergeben, voll ausgeschöpft werden. Insbesondere die durch den elektrisch leitfähigen Montageträger bewirkten thermischen und elektromagnetischen Vorteile kommen bei einer derartigen Ausgestaltung zum Tragen.

Dabei kann das Hochvoltmodul insbesondere einen Leistungsschalter des Pulswechselrichters enthalten. Derartige Leistungsschalter stellen sowohl im Hinblick auf die Wärmeproduktion, als auch im Hinblick auf die elektromagnetische Verträglichkeit Herausforderungen dar. Zudem treten an der elektrischen Schnittstelle zwischen der Leiterplatte einer leistungselektronischen Einrichtung und dem den Leistungsschalter enthaltenden Modul typischerweise hohe Spannungen auf, die durch eine geeignete Isolation beherrscht werden müssen, wofür sich der Aufbau mit der Führungs- und Isolationsplatte besonders eignet.

Bei dem Hochvoltmodul kann es sich um ein Moldmodul handeln. Bei Moldmodulen ist ein elektronisches Bauelement, bei dem es sich insbesondere um den Leistungsschalter eines Pulswechselrichters handeln kann, in einer Vergussmasse (Moldmasse) vergossen. Moldmodule eignen sich in besonderem Maße dafür, über Kontaktstifte, wie insbesondere Press-Fit-Pins, mit Leiterplatten verbunden zu werden. Dabei ist die Verwendung der Einführhilfen im Zusammenhang mit dem Moldmodul besonders vorteilhaft, da Moldmodule typischerweise mit gewissen Toleranzen hinsichtlich der Ausrichtung ihrer Kontaktstifte behaftet sind.

Das Hochvoltmodul weist vorzugsweise ebenfalls eine flächige Gestalt auf. Dabei ist das Hochvoltmodul mit seiner flächigen Erstreckung parallel zur flächigen Erstreckung des Montageträgers und insbesondere der Führungs- und Isolationsplatte und/oder der Leiterplatte ausgerichtet. Eine derartige Ausrichtung ermöglicht zum einen eine kompakte Gestaltung der Hochvoltvorrichtung, zum anderen wird eine gute Kühlung des Hochvoltmoduls ermöglicht. An einer Flächenseite des Hochvoltmoduls kann der Montageträger zur Kühlung beitragen, an der anderen Flächenseite kann eine Kühleinrichtung zur Kühlung des Hochvoltmoduls vorteilhaft angeordnet werden.

Die Kontaktstifte erstrecken sich dabei insbesondere von einer der Flächenseiten des Hochvoltmoduls in, zumindest im Wesentlichen, rechtem Winkel von dem Hochvoltmodul weg. Hochvoltmodule mit einer derartigen Ausrichtung der Kontaktstifte sind zwar im Hinblick auf eine insgesamt kompakte Bauweise der Hochvoltvorrichtung vorteilhaft. Da sich jedoch die Kontaktstifte bei zusammengesetzter Hochvoltvorrichtung von außen unzugänglich zwischen den Bestandteilen der Hochvoltvorrichtung befinden, ist es beim Zusammensetzen der Hochvoltvorrichtung schwierig, mittels an den Kontaktstiften angreifender Werkzeuge für deren exakter Ausrichtung während der Montage Sorge zu tragen (Blindmontage). Daher ist bei derartig gestalteten Hochvoltmodulen eine Führungs- und Isolationsplatte mit Einführhilfen von besonderem Vorteil.

In der Praxis kann die Führungs- und Isolationsplatte derart zwischen der Leiterplatte und dem Montageträger angeordnet sein, dass die dünnwandigen Bereiche des plattenartigen Abschnitts an von der Leiterplatte hervorragenden Hochvoltbauteilen beabstandet angeordnet sind. Damit ist, wie im Zusammenhang mit der Führungs- und Isolationsplatte beschrieben, gemeint, dass die dünnwandigen Bereiche an von der Leiterplatte hervorragenden Bauteilen, insbesondere hervorragenden Hochvoltbauteilen, beabstandet angrenzen. Die von der Leiterplatte hervorragenden Bauteilen können dann sinngemäß in dem plattenartigen Abschnitt einsinken. Anders ausgedrückt kann der plattenartige Abschnitt die hervorragenden Bauteile dann sinngemäß zumindest teilweise umschließen. Die Führungs- und Isolationsplatte kann dadurch insgesamt besonders nahe an der Leiterplatte und/oder dem Montagemodul angeordnet sein. Dadurch ist es in vorteilhafter Weise möglich, den erforderlichen Bauraum zu reduzieren, ohne die mechanische Stabilität und die elektrische Isolationswirkung der Führungs- und Isolationsplatte spürbar zu reduzieren.

Die Erfindung betrifft zudem ein Verfahren zur Herstellung einer hier beschriebenen elektronischen Hochvoltvorrichtung. Das Verfahren umfasst die folgenden Verfahrensschritte:
- Bereitstellen einer Leiterplatte, die eine Mehrzahl von Hochvoltbauteilen, Leiterbahnen und Löchern aufweist;
- Bereitstellen eines Montageträgers mit einem daran angeordneten Hochvoltmodul, wobei das Hochvoltmodul eine Mehrzahl von hervorragenden Kontaktstiften aufweist;
- Bereitstellen einer hier beschriebenen Führungs- und Isolationsplatte und Anordnen an der Leiterplatte derart, dass die dünnwandigen Bereiche des plattenartigen Abschnitts an von der Leiterplatte hervorragenden Hochvoltbauteilen beabstandet angeordnet sind;
- Anordnen des Montageträgers und der mit der Führungs- und Isolationsplatte versehenen Leiterplatte aneinander derart, dass die Kontaktstifte an den Einführhilfen der Führungs- und Isolationsplatte anstehen;
- Einführen der Kontaktstifte in die Einführhilfen, Durchführen der Kontaktstifte durch die Löcher der Leiterplatte und Kontaktieren der Kontaktstifte mit Kontaktstellen der Leiterplatte.

Im Zusammenhang mit dem Herstellungsverfahren wird auch auf die Beschreibung der Führungs- und Isolationsplatte sowie die Beschreibung der Hochvoltvorrichtung Bezug genommen, welche sinngemäß auf das Verfahren übertragen werden.

Da das Anordnen der Führungs- und Isolationsplatte an der Leiterplatte aufgrund von engen Toleranzen schwierig sein kann, weist die Führungs- und Isolationsplatte Zentrierelemente auf und die Leiterplatte umfasst Zentriergegenelemente. Für das Anordnen der Führungs- und Isolationsplatte an der Leiterplatte werden die Zentrierelemente in die Zentriergegenelemente eingeführt, wobei eine Zentrierung der Führungs- und Isolationsplatte relativ zur Leiterplatte erfolgt.

Das Herstellen der mechanischen Verbindung zwischen der Führungs- und Isolationsplatte und der Leiterplatte kann insbesondere ein Heißverstemmen umfassen.

In der Praxis kann die Führungs- und Isolationsplatte eine Isolationsfolie aufweisen. Für das Bereitstellen einer Führungs- und Isolationsplatte mit einer Isolationsfolie kann die Isolationsfolie stückweise lokal in oder an den dünnwandigen Bereichen angeordnet sein, oder die Isolationsfolie kann in oder an dem gesamten plattenartigen Abschnitt der Führungs- und Isolationsplatte vorgesehen sein. In diesem Zusammenhang wird explizit auf die Beschreibung der mehrteiligen Ausbildung der Führungs- und Isolationsplatte verwiesen, welche sinngemäß auf das Herstellungsverfahren übertragen wird.

Wenn an dem gesamten plattenartigen Abschnitt der Führungs- und Isolationsplatte die Isolationsfolie angebracht wird, können die Einführhilfen in der Praxis vor dem Applizieren der Isolationsfolie mittels einer Maskierung abgedeckt werden. Nach dem Anbringen der Maskierung an den Einführhilfen kann die Isolationsfolie an der Führungs- und Isolationsplatte angelegt und mit dieser verbunden werden, beispielsweise indem die Isolationsfolie mit dem Grundmaterial der Führungs- und Isolationsplatte verschweißt wird. Die Maskierung sorgt entweder dafür, dass die Isolationsfolie keine Bindung eingeht, oder dass die Isolationsfolie und die Maskierung nach dem Applizieren der Isolationsfolie einfach wieder entfernt werden können. Das Entfernen kann beispielsweise ein Ausstanzen oder Ausschneiden der Folie und/oder der Maskierung umfassen.

Weitere praktische Ausführungsformen der Erfindung sind nachfolgend im Zusammenhang mit den Zeichnungen beschrieben. Es zeigen:
- Fig. 1: eine schematische perspektivische Darstellung einer beispielhaften Hochvoltvorrichtung,
- Fig. 2: die Hochvoltvorrichtung aus Figur 1 ohne die Leiterplatte mit Blick auf die Führungs- und Isolationsplatte,
- Fig. 3: die Leiterplatte aus Figur 1 mit daran befestigter Führungs- und Isolationsplatte,
- Fig. 4: eine schematische Schnittdarstellung durch die in Figur 1 dargestellte Hochvoltvorrichtung,
- Fig. 5-9: beispielhafte alternative Ausführungsformen der Führungs- und Isolationsplatte.

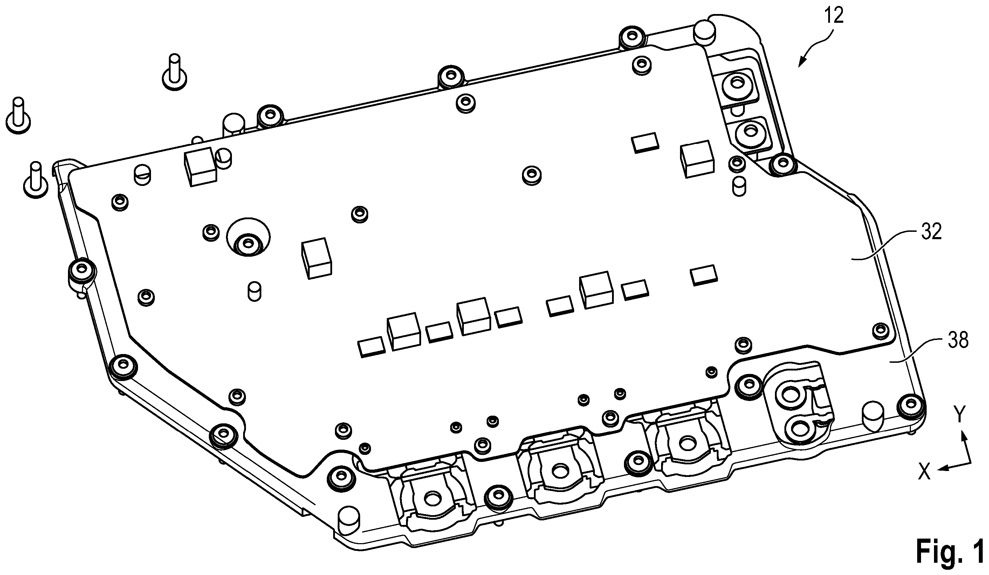

In den Figuren 1 bis 9 bezeichnen übereinstimmende Bezugszeichen in unterschiedlichen Figuren gleiche oder funktionsgleiche technische Elemente oder Verfahrensschritte. Zur besseren Übersicht sind in den Figuren nicht alle Bezugszeichen gesetzt, obwohl die Elemente dennoch in den Figuren vorhanden sein können.

In den Figuren 1 bis 4 ist beispielhaft eine eine Führungs- und Isolationsplatte 10 aufweisende Hochvoltvorrichtung 12 dargestellt.

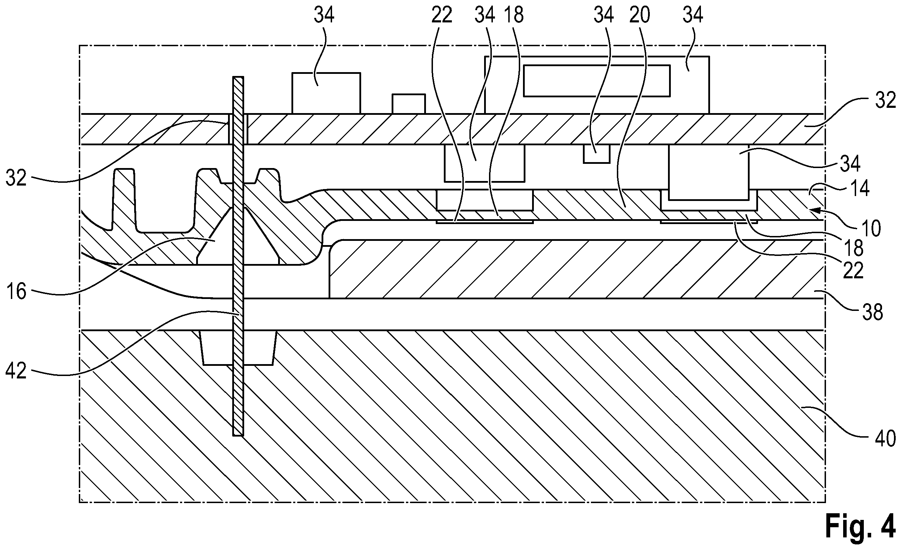

Die Führungs- und Isolationsplatte 10 der Hochvoltvorrichtung 12 weist einen plattenartigen Abschnitt 14 und eine Mehrzahl von in dem plattenartigen Abschnitt 14 eingefassten Einführhilfen 16 auf. Wie insbesondere in Figur 4 zu erkennen ist, können die Einführhilfen 16 als sich verjüngende Durchlässe und weiter insbesondere trichterartig ausgebildet sein. In dem plattenartigen Abschnitt 14 sind lokale, dünnwandige Bereiche 18 und dickwandige Bereiche 20, die die dünnwandigen Bereiche 18 in der Erstreckungsebene der Führungs- und Isolationsplatte 10 (xy-Ebene) umgeben, ausgebildet. Zumindest die dünnwandigen Bereiche 18 weisen eine Isolationsfolie 22 zur elektrischen Isolation auf, die mit einem Grundmaterial 24 des plattenartigen Abschnitts 14 formschlüssig und/oder stoffschlüssig verbunden sein kann. In den Figuren ist die vorgenannte Verbindung als stoffschlüssige Verbindung ausgebildet dargestellt, welche beispielsweise mittels Laserstrahlschweißens hergestellt sein kann. Details zu den dünnwandigen Bereichen 18, den dickwandigen Bereichen 20 und der Isolationsfolie 22 werden nachfolgend im Zusammenhang mit den Figuren 4 bis 7 beschrieben.

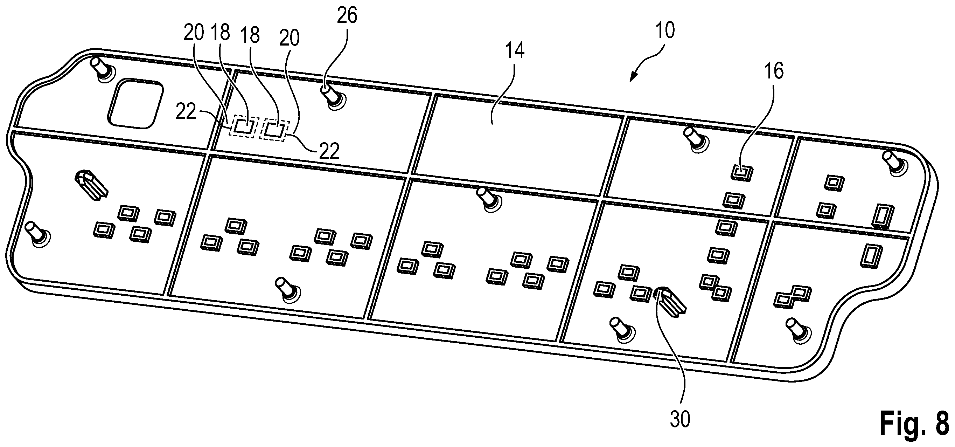

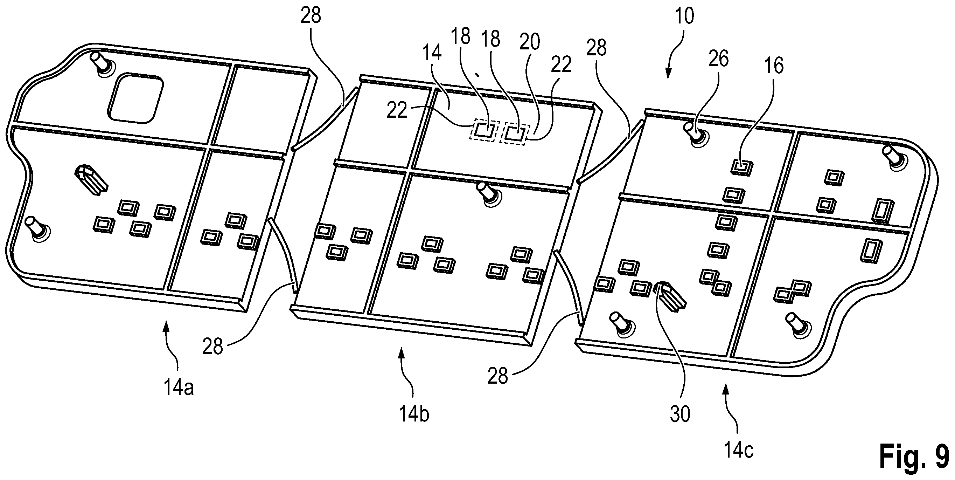

Die Führungs- und Isolationsplatte 10 weist ferner angeformte Befestigungsmittel 26 auf, mit welchen die Führungs- und Isolationsplatte 10 in der Hochvoltvorrichtung 12 an einem Gegenelement befestigt werden kann, beispielsweise mittels Heißverstemmens. Ferner kann die Führungs- und Isolationsplatte 10 elastische Verbindungselemente 28 und Zentrierelemente 30 aufweisen, welche in den Figuren 8 und 9 gezeigt sind und nachfolgend im Zusammenhang mit diesen Figuren im Detail beschrieben werden.

Zusätzlich zu der Führungs- und Isolationsplatte 10 weist die Hochvoltvorrichtung 12 eine Leiterplatte 32 mit einer Mehrzahl von Hochvoltbauteilen 34, Leiterbahnen (nicht gezeigt) und Löchern 36 sowie einen elektrisch leitfähigen Montageträger 38 und ein an dem Montageträger 38 angeordnetes Hochvoltmodul 40 auf. Die Hochvoltbauteile 34 ragen unterschiedlich weit von der oberen und der unteren Seite der Leiterplatte 32 hervor.

Die Führungs- und Isolationsplatte 10 ist zwischen einem Abschnitt der Leiterplatte 32 und dem Montageträger 38 angeordnet, so dass eine Mehrzahl von aus dem Hochvoltmodul 40 hervorragenden Kontaktstiften 42 die Löcher 36 der Leiterplatte 32 durchragt. Dabei kann es sich bei den Kontaktstiften 42 insbesondere um Press-Fit-Pins handeln. Die Kontaktstifte 42 sind insbesondere kraftschlüssig in den Löchern 36 der Leiterplatte 32 aufgenommen.

Der elektrisch leitfähige, im gezeigten Beispiel aus einem metallischen Werkstoff ausgebildete Montageträger 38 dient zur Befestigung des Hochvoltmoduls 40 und der Leiterplatte 32. Wie im gezeigten Beispiel können sich die Leiterplatte 32 und der Montageträger 38 flächig in zueinander parallelen Erstreckungsebenen erstrecken.

In der Hochvoltvorrichtung 12 erstreckt sich die Führungs- und Isolationsplatte 10 insbesondere ebenfalls flächig in einer zur Erstreckungsebene des Montageträgers 38 und/oder der Leiterplatte 32 parallelen Ebene. Auf diese Weise erstreckt sich die Führungs- und Isolationsplatte 10 insbesondere, wie in Figur 4 zu erkennen ist, in einem zwischen dem Montageträger 38 und der Leiterplatte 32 ausgebildeten Zwischenraum.

Aufgrund der beschriebenen Ausbildung der Führungs- und Isolationsplatte 10 und der beschriebenen Anordnung in der Hochvoltvorrichtung 12 können die Einführhilfen 16 der Führungs- und Isolationsplatte 10 zum Ausrichten der Kontaktstifte 42 auf die Löcher 36 in der Leiterplatte 32 beim Zusammenbau der Hochvoltvorrichtung 12 dienen. Insgesamt kann somit die Führungs- und Isolationsplatte 10 gleichermaßen zur Vereinfachung des Zusammenbaus der Hochvoltvorrichtung 12 und zu einer besonders kompakt ausgebildeten Hochvoltvorrichtung 12 beitragen. Die kompakte Ausbildung kann insbesondere aufgrund der dünnwandigen und dickwandigen Bereiche 18, 20 der Führungs- und Isolationsplatte 10 erzielt werden. Wie aus Figur 4 ersichtlich ist, sind die dünnwandigen Bereiche 18 beabstandet angrenzend an den von der Leiterplatte 32 in Richtung der Führungs- und Isolationsplatte 10 hervorragenden Hochvoltbauteilen 34 angeordnet. Einige der Hochvoltbauteile 34 werden zumindest teilweise von dem plattenartigen Abschnitt 14 der Führungs- und Isolationsplatte 10 umfasst. Die dickwandigen Bereiche 20 sind insbesondere derart ausgebildet und angeordnet, dass trotz der höheren Wanddicke des plattenartigen Abschnitts 14 ein für die elektrische Isolation ausreichender Abstand zu der Leiterplatte 32 und insbesondere zu den Hochvoltbauteilen 34 eingehalten werden kann. Dadurch kann der Bauraum optimal ausgenutzt werden.

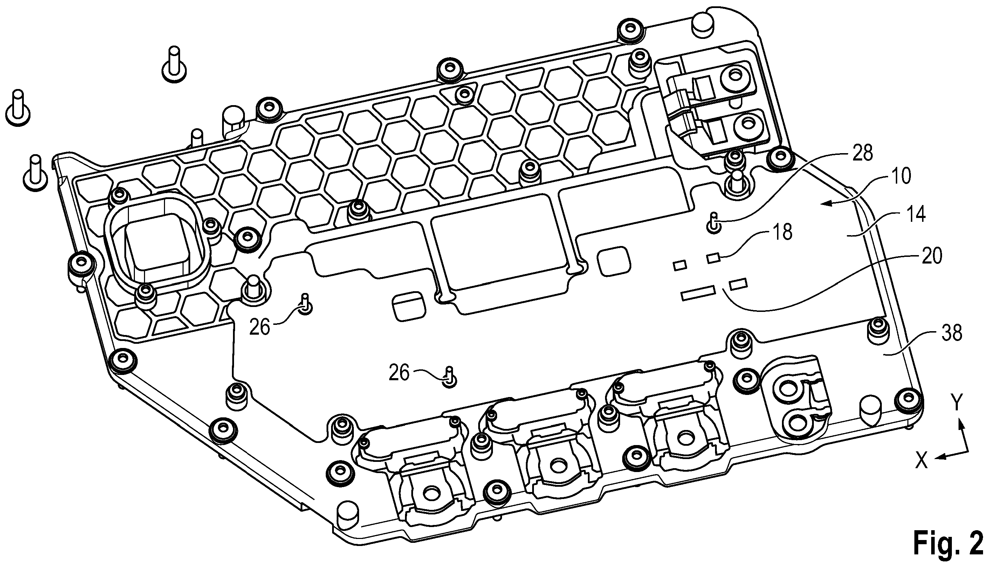

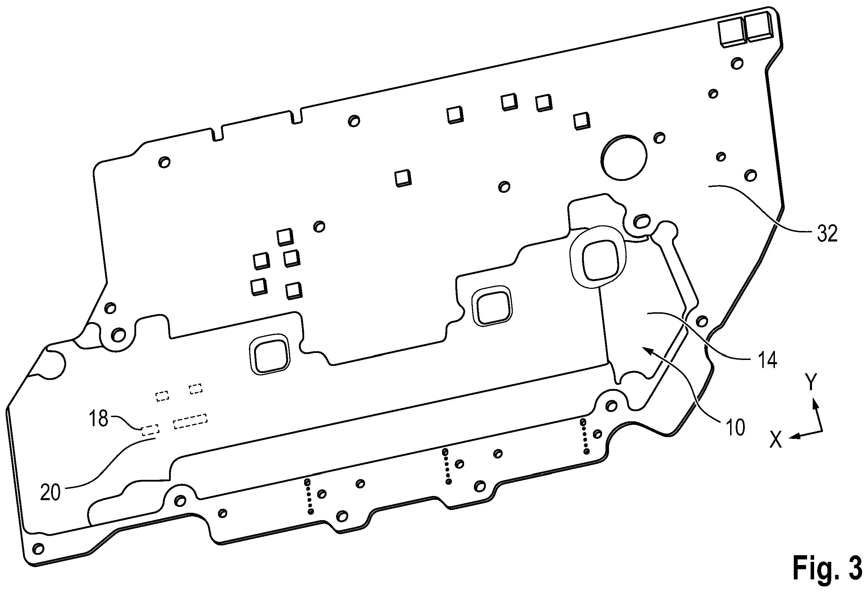

Wie im gezeigten Beispiel kann die Führungs- und Isolationsplatte 10 sich lediglich über einen Abschnitt des Zwischenraums zwischen der Leiterplatte 32 und dem Montageträger 38 erstrecken. Dies ist in den Figuren insbesondere anhand der Figuren 2 und 3 zu erkennen, aus denen aufgrund der unterschiedlich gewählten Perspektiven in Figur 3 die relative Lage der Führungs- und Isolationsplatte 10 zur Leiterplatte 32 und in der Figur 2 die relative Lage der Führungs- und Isolationsplatte 10 zum Montageträger 38 hervorgeht.

Aus dem Vergleich der Figuren 2 und 3 geht auch hervor, dass die Leiterplatte 32 und der Montageträger 38 dort, wo sich die Führungs- und Isolationsplatte 10 nicht zwischen Montageträger 38 und Leiterplatte 32 erstreckt, unmittelbar benachbart angeordnet und somit wie im gezeigten Beispiel lediglich durch eine Luftstrecke voneinander getrennt sein können.

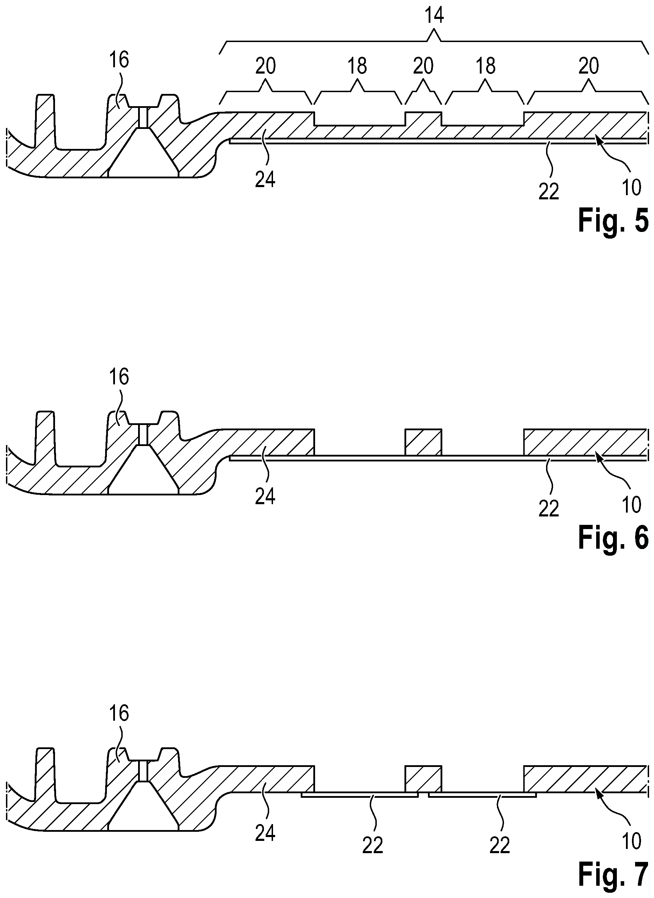

Anhand der in den Figuren 5 bis 9 dargestellten beispielhaften Varianten der Führungs- und Isolationsplatte 10 lassen sich weitere beispielhafte Ausgestaltungen erkennen. Dabei zeigen die Figuren 5 bis 7 die Führungs- und Isolationsplatte 10 in zur Figur 4 analogen Schnittdarstellungen und die Figuren 8 und 9 zeigen die Führungs- und Isolationsplatte 10 in einer Ansicht von schräg oben. Hinsichtlich der Varianten der Führungs- und Isolationsplatte 10 werden nachfolgend nur die Unterschiede zu der aus Figur 4 ersichtlichen Führungs- und Isolationsplatte 10 beschrieben.

Die in den Figuren 4 bis 7 dargestellten Varianten der Führungs- und Isolationsplatte 10 weisen einen aus dem Grundmaterial 24 als Spritzgussteil gebildeten Grundkörper auf, welcher zumindest die dickwandigen Bereiche 20 und die damit einteilig ausgebildeten Einführhilfen 16 umfasst. Bei den in den Figuren 4 bis 6 gezeigten Varianten umfasst dieser Grundkörper auch einen Bestandteil der dünnwandigen Bereiche 18.

Die dünnwandigen Bereiche 18 der in den Figuren 4 bis 6 dargestellten Varianten umfassen zudem die Isolationsfolie 22. Bei der in Figur 7 gezeigten Variante besteht der dünnwandige Bereich 18 ausschließlich aus der Isolationsfolie 22. Der plattenartige Abschnitt 14 der in den Figuren 4 bis 7 gezeigten Varianten der Führungs- und Isolationsplatte 10 ist insofern mehrteilig ausgebildet.

Der plattenartige Abschnitt 14 der in den Figuren 4 bis 7 gezeigten Varianten kann beispielsweise mit Vertiefungen und/oder Aussparungen mittels Spritzguss hergestellt und die dünnwandigen Bereiche 18 in einem zweiten Schritt durch Anbringen der Isolationsfolie 22 an dem die Vertiefungen und/oder Aussparungen angrenzenden Grundmaterial 24 fertiggestellt werden.

Dabei kann die Isolationsfolie 22, wie in Figur 4 gezeigt, lokal an Vertiefungen in dem plattenartigen Abschnitt 14 angebracht werden. Alternativ kann die Isolationsfolie 22, wie in Figur 5 gezeigt, großflächig an Vertiefungen und an den dickwandigen Bereichen 20 des plattenartigen Abschnitts 14 angebracht werden. Wieder alternativ kann die Isolationsfolie 22, wie in Figur 6 gezeigt, großflächig an Aussparungen in dem plattenartigen Abschnitt 14 und an den dickwandigen Bereichen 20 des plattenartigen Abschnitts 14 angebracht werden. Zuletzt kann die Isolationsfolie 22 auch, wie in Figur 7 gezeigt, lokal an Aussparungen in dem plattenartigen Abschnitt 14 angeordnet werden, um so den dünnwandigen Bereich auszubilden. In Ergänzung zu der vorausgehenden Beschreibung kann die Isolationsfolie 22 auch zumindest teilweise von dem Grundmaterial 24 umgeben in dem plattenartigen Abschnitt 14 vorgesehen sein, beispielsweise durch Umspritzen der Isolationsfolie 22 mit dem Grundmaterial 24 (nicht dargestellt), um eine formschlüssige Verbindung der Isolationsfolie 22 mit dem plattenartigen Abschnitt 14 auszubilden.

Die Isolationsfolie 22 kann insbesondere als eine Verbund-Isolationsfolie ausgebildet sein und eine Mehrzahl von aufeinander geschichteten Folien umfassen (nicht gezeigt). Insbesondere weist die Verbund-Isolationsfolie eine Glimmer aufweisende Folie zur Erhöhung der elektrischen Isolation, eine Folie zur Einstellung einer definierten Wärmeleitfähigkeit und eine Folie zur Verbesserung der Brandschutzfestigkeit auf.

Gemäß den in den Figuren 8 und 9 gezeigten Beispielen der Führungs- und Isolationsplatte 10 können die Einführhilfen 16 einen eckigen Querschnitt aufweisen. Auch kann die Führungs- und Isolationsplatte 10 Zentrierelemente 30 aufweisen, um die Führungs- und Isolationsplatte 10 relativ zur Leiterplatte 32 bei der Montage räumlich auszurichten. Wie insbesondere aus der Figur 9 ersichtlich ist, kann die Führungs- und Isolationsplatte 10 weiterhin eine Mehrzahl von mittels elastischer Verbindungselemente 28 miteinander verbundener, flächiger Segmente 14a, 14b, 14c aufweisen. Aufgrund der elastischen Verbindungselemente 28 können die einzelnen Segmente 14a, 14b, 14c beweglich miteinander verbunden sein.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung kann im Rahmen der Ansprüche und unter Berücksichtigung der Kenntnisse des zuständigen Fachmanns variiert werden.

### Bezugszeichenliste

- 10: Führungs- und Isolationsplatte
- 12: Hochvoltvorrichtung
- 14: plattenartiger Abschnitt
- 14a, 14b, 14c: Segmente des plattenartigen Abschnitts
- 16: Einführhilfen
- 18: dünnwandige Bereiche
- 20: dickwandige Bereiche
- 22: Isolationsfolie
- 24: Grundmaterial
- 26: Befestigungsmittel
- 28: elastischer Verbindungselemente
- 30: Zentrierelemente
- 32: Leiterplatte
- 34: Hochvoltbauteile
- 36: Löcher
- 38: Montageträger
- 40: Hochvoltmodul
- 42: Kontaktstifte

## Patentansprüche

1. Führungs- und Isolationsplatte (10) für eine elektronische, eine Leiterplatte aufweisende Hochvoltvorrichtung (12), wobei die Führungs- und Isolationsplatte (10) einen plattenartigen Abschnitt (14) und eine Mehrzahl von in dem plattenartigen Abschnitt (14) eingefassten Einführhilfen (16) aufweist, **dadurch gekennzeichnet, dass** der plattenartige Abschnitt (14) lokal ausgebildete, dünnwandige Bereiche (18) und dickwandige Bereiche (20) aufweist.

2. Führungs- und Isolationsplatte (10) nach Anspruch 1, **dadurch gekennzeichnet, dass** zumindest die dünnwandigen Bereiche (18) eine Isolationsfolie (22) zur elektrischen Isolation aufweisen.

3. Führungs- und Isolationsplatte (10) nach dem vorausgehenden Anspruch, **dadurch gekennzeichnet, dass** die Isolationsfolie (22) stückweise lokal in oder an den dünnwandigen Bereichen (18) angeordnet ist.

4. Führungs- und Isolationsplatte (10) nach Anspruch 3, **dadurch gekennzeichnet, dass** die Isolationsfolie (22) als eine Verbund-Isolationsfolie ausgebildet ist, welche eine Mehrzahl von aufeinander geschichteten Folien aufweist.

5. Führungs- und Isolationsplatte (10) nach einem der Ansprüche 3 oder 4, **dadurch gekennzeichnet, dass** die Isolationsfolie (22) und ein Grundmaterial (24) des plattenartigen Abschnitts (14) formschlüssig und/oder stoffschlüssig verbunden sind.

6. Führungs- und Isolationsplatte (10) nach einem der vorausgehenden Ansprüche, **dadurch gekennzeichnet, dass** der plattenartige Abschnitt (14) segmentiert ausgebildet ist, wobei mindestens zwei Segmente (14a, 14b, 14c) des plattenartigen Abschnitts (14) mittels elastischer Verbindungselemente (28) miteinander verbundenen sind und/oder dass der plattenartige Abschnitt (14) eine Mehrzahl von Zentrierelementen (30) aufweist.

7. Elektronische Hochvoltvorrichtung (12), insbesondere Hochvolt-Steuervorrichtung eines Kraftfahrzeugs, umfassend
- eine Leiterplatte (32), die eine Mehrzahl von Hochvoltbauteilen (34), Leiterbahnen und Löchern (36) aufweist,
- einen elektrisch leitfähigen Montageträger (38), und
- ein an dem elektrisch leitfähigen Montageträger (38) angeordnetes Hochvoltmodul (40), das eine Mehrzahl von hervorragenden und die Löcher (36) der Leiterplatte (32) hindurchragenden Kontaktstifte (42) aufweist,
**dadurch gekennzeichnet, dass** die elektronische Hochvoltvorrichtung (12) eine Führungs- und Isolationsplatte (10) nach einem der vorstehenden Ansprüche aufweist, wobei die Führungs- und Isolationsplatte (10) zwischen mindestens einem Abschnitt der Leiterplatte (32) und dem Montageträger (38) angeordnet ist.

8. Elektronische Hochvoltvorrichtung (12) nach dem vorstehenden Anspruch, **dadurch gekennzeichnet, dass** die Führungs- und Isolationsplatte (10) derart zwischen der Leiterplatte (32) und dem Montageträger (38) angeordnet ist, dass die dünnwandigen Bereiche (18) des plattenartigen Abschnitts (14) an von der Leiterplatte (32) hervorragenden Hochvoltbauteilen (34) beabstandet angeordnet sind.

9. Verfahren zur Herstellung einer elektronischen Hochvoltvorrichtung (12) nach einem der vorstehenden Ansprüche, wobei das Verfahren die folgenden Verfahrensschritte umfasst:
- - Bereitstellen einer Leiterplatte (32), die eine Mehrzahl von Hochvoltbauteilen (34), Leiterbahnen und Löchern (36) aufweist;
- - Bereitstellen eines Montageträgers (38) mit einem daran angeordneten Hochvoltmodul (40), wobei das Hochvoltmodul (40) eine Mehrzahl von hervorragenden Kontaktstiften (42) aufweist;
- - Bereitstellen einer Führungs- und Isolationsplatte (10) gemäß einem der vorausgehenden Ansprüche und Anordnen an der Leiterplatte (32) derart, dass die dünnwandigen Bereiche (18) des plattenartigen Abschnitts (14) an von der Leiterplatte (32) hervorragenden Hochvoltbauteilen (34) beabstandet angeordnet sind;
- - Anordnen des Montageträgers (38) und der mit der Führungs- und Isolationsplatte (10) versehenen Leiterplatte (32) aneinander derart, dass die Kontaktstifte (42) an den Einführhilfen (16) der Führungs- und Isolationsplatte (10) anstehen;
- - Einführen der Kontaktstifte (42) in die Einführhilfen (16), Durchführen der Kontaktstifte (42) durch die Löcher (36) der Leiterplatte (32) und Kontaktieren der Kontaktstifte (42) mit Kontaktstellen der Leiterplatte (32).

10. Verfahren nach dem vorausgehenden Anspruch, **dadurch gekennzeichnet, dass** an dem gesamten plattenartigen Abschnitt (14) der Führungs- und Isolationsplatte (10) die Isolationsfolie (22) angebracht wird, wobei die Einführhilfen (16) vor dem Applizieren der Isolationsfolie (22) mittels einer Maskierung abgedeckt werden.
